# EUROPÄISCHE PATENTSCHRIFT

(11) **EP 1 479 788 B1**
(45) Veröffentlichungstag und Bekanntmachung des Hinweises auf die Patenterteilung: **28.11.2007**
(21) Anmeldenummer: 04405254.6
(22) Anmeldetag: 26.04.2004
(51) Int. Cl.: C23C 4/12

(54) **Hybrides Verfahren zum Beschichten eines Substrats durch ein thermisches Aufbringen der Beschichtung**
Hybrid process for coating a substrate by thermal application of the coating
Procédé hybride thermique pour le dépôt d'un revêtment sur un substrat

(30) Priorität: 23.05.2003 EP 03405368
(43) Veröffentlichungstag der Anmeldung: 24.11.2004
(73) Patentinhaber: Sulzer Metco AG, 5610 Wohlen (CH)
(72) Erfinder: Schmid, Richard K., Dr., Melville, NY 11747 (US); Refke, Arno, Dr., 5507 Mellingen (CH); Barbezat, Gérard, 8152 Opfikon (CH); Hawley, David, Kings Park, NY 11754 (US)
(74) Vertreter: Sulzer Management AG

(56) Entgegenhaltungen:
- WO-A-02/19455
- DE-A- 3 435 748
- DE-A- 3 623 044
- US-A- 5 853 815
- LETHINEN T ET AL: "Correlations Between In-Flight Particle Concentrations and Coating Properties in Atmospheric Plasma Spraying of Alumina" PROCEEDINGS OF THE NATIONAL THERMAL SPRAY CONFERENCE, XX, XX, 7. Oktober 1996 (1996-10-07), Seiten 525-530, XP002954288
- PATENT ABSTRACTS OF JAPAN Bd. 015, Nr. 064 (C-0806), 15. Februar 1991 (1991-02-15) & JP 02 290959 A (NIPPON STEEL CORP), 30. November 1990 (1990-11-30)

## Beschreibung

Die Erfindung betrifft ein hybrides Verfahren zum Beschichten eines Substrats durch ein thermisches Aufbringen der Beschichtung gemäss Oberbegriff von Anspruch 1 sowie Anwendungen des Verfahrens. Mit dem Verfahren lassen sich dünne Schichten mit spezifischen Gefügestrukturen und mit Schichtdicken im Bereich von 1 - 800 µm erzeugen.

Das Substrat wird beschichtet, indem ein Beschichtungsmaterial mit einem thermischen Prozessstrahl aufgetragen wird. Der Prozessstrahl bildet einen von Plasma durchströmten Raum, in dem das Beschichtungsmaterial zusammen mit einem Prozessgasgemisch transportiert wird. Das Plasma wird mittels elektrischer Gasentladung, elektromagnetischer Induktion oder Mikrowellen erzeugt. Ein vorteilhaftes Verfahren, bei dem ein besonderer Prozessstrahl erzeugt wird, ist in der US-A- 5 853 815 beschrieben. Mit diesem Verfahren wird ein sogenannter LPPS-Dünnfilm (LPPS = Low Pressure Plasma Spraying) auf das Substrat aufgetragen.

Mit dem LPPS-Dünnfilm-Prozess wird ein konventionelles LPPS-Plasmaspritzverfahren verfahrenstechnisch abgewandelt. Das Beschichtungsmaterial wird pulverförmig und mit einem Fördergas in das Plasma injiziert. Eine starke räumliche Ausdehnung des Plasmas führt zu einer "Defokussierung" des Pulverstrahls. Dabei wird das Pulver zu einer Wolke dispergiert und aufgrund einer hohen Enthalpie des Plasmas geschmolzen sowie gegebenenfalls teilweise verdampft. Das Beschichtungsmaterial gelangt gleichmässig verteilt auf eine weit ausgedehnte Oberfläche des Substrats. Es wird eine dünne Lage abgeschieden, deren Schichtdicke kleiner als 10 µm ist und die dank der gleichmässigen Verteilung eine dichte Abdeckung bildet. Durch einen mehrfachen Auftrag von dünnen Lagen kann gezielt eine dickere Beschichtung mit besonderen Eigenschaften hergestellt werden.

Eine solche Beschichtung ist als Funktionsschicht verwendbar. Auf einem Grundkörper, der das Substrat bildet, kann eine Funktionsschicht aufgebracht werden, die in der Regel verschiedene Teilschichten umfasst. Beispielsweise werden für Gasturbinen (stationäre Gasturbine oder Flugzeugtriebwerk), die bei hohen Prozesstemperaturen betrieben werden, die Schaufeln mit einer ersten ein- oder mehrlagigen Teilschicht beschichtet, so dass das Substrat beständig gegen Heissgaskorrosion wird. Eine zweite, auf der ersten Teilschicht aufgebrachte Beschichtung - aus keramischem Material - bildet eine Wärmedämmschicht. In der EP-A- 1 260 602 ist ein Verfahren zum Erzeugen eines derartigen wärmedämmenden Schichtsystems beschrieben, bei dem eine Mehrzahl von Einzelschichten (Sperrschicht, Schutzschicht, Wärmedämmschicht und/oder Glättungsschicht) durch eine wechselnde Einstellung von steuerbaren Prozessparametern in einem Arbeitszyklus aufgebracht werden können. Die Prozessparameter sind Druck sowie Enthalpie des Plasmas, Zusammensetzung des Prozessgases und Zusammensetzung sowie Applikationsform des Beschichtungsmaterials.

Aufgabe der Erfindung ist es, ein Verfahren zum Beschichten eines Substrats durch ein thermisches Aufbringen der Beschichtung, insbesondere durch eine Kombination aus thermischem Spritzen und reaktiver Dampfphasenabscheidung zu schaffen, mit dem sich gezielt eine Beschichtung mit spezifischer Gefügestruktur - sowohl eine homogene, heterogene als auch mehrlagige Beschichtung - herstellen lässt. Diese Aufgabe wird durch das im Anspruch 1 definierte Verfahren gelöst.

Bei dem Verfahren zum Beschichten eines Substrats wird mit einem thermischen Prozessstrahl ein hybrides Beschichtungsverfahren durchgeführt, welches es ermöglicht, die Eigenschaften eines thermischen Spritzverfahrens mit denen einer Dampfphasenabscheidung zu kombinieren. Die Eigenschaften des Prozessstrahls sind durch steuerbare Prozessparameter bestimmt, insbesondere durch die Parameter Druck, Enthalpie, Zusammensetzung eines Prozessgasgemisches und Zusammensetzung sowie Applikationsform eines Beschichtungsmaterials. Das Beschichtungsmaterial wird in Abhängigkeit von den steuerbaren Parametern teilweise oder vollständig verdampft. Die in dampfförmiger und gegebenenfalls kondensierter, d.h. fester oder flüssiger Form vorliegenden Phasen des Beschichtungsmaterials werden auf dem Substrat zumindest teilweise abgeschieden. Für das im Prozessstrahl transportierte Beschichtungsmaterial wird der relative Anteil an Dampf und/oder an kondensierter Phase durch ein diagnostisches Messverfahren bestimmt. Mit derart gewonnenen Messdaten werden die steuerbaren Prozessparameter in Bezug auf Sollwerte eingestellt. Bezüglich diesen Sollwerten, welche einem vorgegebenen Dampfanteil oder Anteil an kondensierter Phase entsprechen, wird eine Regelung zur gezielten Herstellung der Beschichtung, insbesondere eines mehrlagigen Schichtsystems, durchgeführt.

Das erfindungsgemässe Verfahren ist ein hybrides Beschichtungsverfahren, bei dem dampfförmige und kondensierte Phasen des Beschichtungsmaterials aufgetragen werden. Es vereinigt dabei die Eigenschaften und Möglichkeiten eines thermischen Beschichtungsverfahrens mit denen einer Dampfphasenabscheidung, insbesondere einer reaktiven Abscheidung. Mit einer Messvorrichtung werden die Phasen im Prozessstrahl überwacht und über eine Einstellung geeigneter Prozessparameter das hybride Verfahren geregelt. Durch die Regelung des Zustandes des Beschichtungsmaterials im Prozessstrahl wird eine kontrollierte Einstellung der gewünschten Schichtstruktur auf dem Substrat ermöglicht.

Die abhängigen Ansprüche 2 bis 10 betreffen vorteilhafte Ausführungsformen des erfindungsgemässen Verfahrens. Das erfindungsgemässe Verfahren anzuwenden ist Gegenstand der Ansprüche 11 bis 13.

Nachfolgend wird die Erfindung anhand der Zeichnung erläutert. Es zeigt:

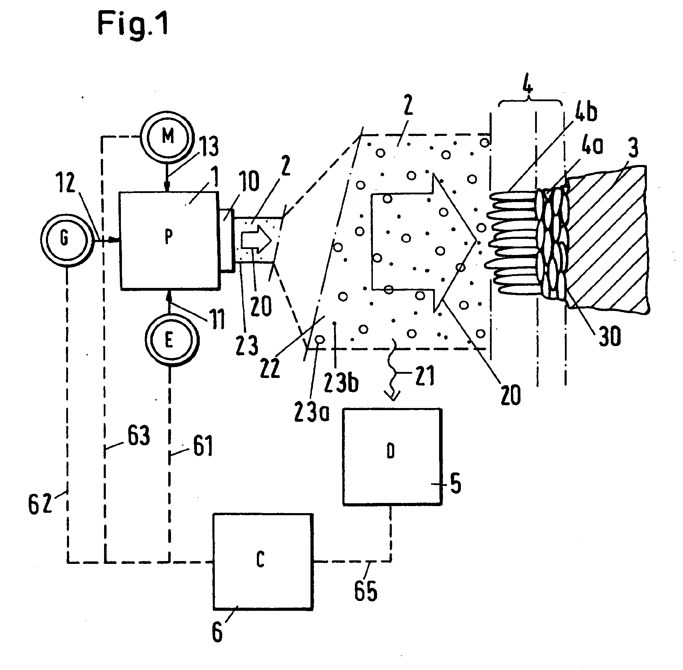

- Fig. 1: eine schematische Darstellung einer Anlage, mit der das erfindungsgemässe Verfahren durchgeführt wird.

Mit der gezeigten Anlage wird ein thermisches Beschichtungsverfahren eingesetzt, das beispielsweise auf dem LPPS-Dünnfilm Prozess basiert und bei dem das Beschichtungsmaterial auf eine Oberfläche 30 eines Substrates 3 aufgebracht wird. Die Anlage umfasst eine Vorrichtung 1, in der mit einem bekannten Verfahren P aus einem Beschichtungsmaterial M, einem Prozessgasgemisch G und elektrischer Energie E ein Prozessstrahl 2 erzeugt wird. Die Einspeisung dieser Komponenten E, G und M ist durch die Pfeile 11, 12 und 13 symbolisiert. Der erzeugte Prozessstrahl 2 tritt durch eine Düse 10 aus und transportiert das Beschichtungsmaterial M in Form eines Pulverstrahls oder Prekursors, in dem Materialpartikel 23 in einem Plasma 22 dispergiert sind. Dieser Transport ist durch den Pfeil 20 symbolisiert. In der rechten Hälfte der Fig. 1 ist der Prozessstrahl 2 vergrössert dargestellt. Die Materialpartikel 23 sind in der Regel Pulverpartikel; sie können aber auch aus einer Flüssigkeit oder Dispersion bestehen. Die Morphologie eines auf dem Substrat 3 abgeschiedenen Schichtsystems 4 ist von den Prozessparametern abhängig und insbesondere vom Beschichtungsmaterial M, der Prozessenthalpie und der Temperatur des Substrats 3.

Mit Vorteil wird bei einem niedrigen Prozessdruck, der kleiner als 10 000 Pa ist, das Beschichtungsmaterial M in ein den Materialstrahl defokussierendes Plasma injiziert und darin teilweise oder vollständig geschmolzen. Wird ein Plasma mit ausreichend hoher spezifischer Enthalpie erzeugt, so geht ein substanzieller Anteil der Materialpartikel 23 in die Dampfphase über. Es kann so eine strukturierte Schicht entstehen, die eine Teilschicht 4b des Schichtsystems 4 ist. Es können strukturierte Schichten entstehen, die lamellare, kolumnare bzw. gemischte Gefügestrukturen aufzeigen. Die Variation der Gefüge sind durch die Beschichtungsbedingungen, insbesondere von Prozess-Enthalpie, Arbeitsdruck in der Beschichtungskammer sowie Prekursor wesentlich beeinflusst und steuerbar. Das Schichtsystem 4 in Fig. 1 weist eine zweilagige Schichtstruktur auf. In der Regel werden mehr als zwei Teilschichten abgeschieden. Eine Grundsschicht 4a des Schichtsystems 4 hat eine lamellare Struktur, die sich bei einer kleineren Enthalpie ergibt, wie diese bei üblichen thermischen Spritzschichten verwendet wird. In der zweiten Teilschicht 4b bilden längliche Korpuskeln eine anisotrope Mikrostruktur. Die Korpuskeln, die senkrecht zur Substratoberfläche 30 stehend ausgerichtet sind, werden durch materialarme Übergangsbereiche gegeneinander begrenzt.

Der Prozessstrahl 2 hat Eigenschaften, die durch steuerbare Prozessparameter bestimmt werden. Es werden Photonen 21 vom Plasma 22 emittiert, die Rückschlüsse auf die Eigenschaften des Prozessstrahls 2 ermöglichen. Die im Prozessstrahl 2 mitgeführte Materialpartikel 23 werden in Abhängigkeit von den steuerbaren Parametern teilweise oder vollständig verdampft. Die Materialpartikel 23 bilden schliesslich eine kondensierte, d.h. in fester oder flüssiger Form vorliegende Phase 23a und eine dampfförmige Phase 23b. Erfindungsgemäss wird der relative Anteil an Dampf 23b und/oder an kondensierter Phase 23a durch ein diagnostisches Messverfahren D mit einer Einrichtung 5 bestimmt.

Mit den durch das Verfahren D gewonnenen Messdaten werden die steuerbaren Prozessparameter in Bezug auf Sollwerte eingestellt. Diese Sollwerte entsprechen einem Dampfanteil oder Anteil an kondensierter Phase, die für die gezielte Schichtherstellung einzuhalten sind. Mit einer Einrichtung 6, der die Messdaten über eine Signalleitung 65 übermittelt werden, wird eine Regelung C bezüglich den Sollwerten durchgeführt, um die besondere Schichtstruktur herzustellen, die beispielsweise homogen oder heterogen, insbesondere mehrlagig sein soll. Über Signalleitungen 61, 62 und 63 werden die Prozessparamter eingestellt.

Zur Diagnostik des Prozessstrahls 2 wird mit Vorteil ein optisches Messverfahren D angewendet, bei dem insbesondere der Dampfanteil mittels eines spektroskopischen oder pyrometrischen Verfahrens bestimmt wird. Es kann auch der Anteil der kondensierten Phase 23a, die in Form einer Vielzahl von Tröpfchen und/oder Partikeln vorliegt, mittels einer Streulichtmessung unter Verwendung einer Hilfslichtquelle, insbesondere eines Lasers bestimmt werden. Es können auch zwei oder mehr Messverfahren D kombiniert werden.

Die Applikationsform, in der das Beschichtungsmaterial M in den Prozessstrom 2 injiziert wird (Pfeil 13), kann ein Pulver und/oder eine Flüssigkeit, insbesondere eine Suspension sein, und/oder ein Gas, insbesondere ein gasförmiger Prekursor, wobei unter Verwendung mehrerer Injektoren sich wahlweise verschiedene Ausgangsmaterialien gleichzeitig injizieren lassen.

Für das Beschichtungsmaterial M können metallische und/oder nichtmetallische, insbesondere oxidkeramische Stoffe verwendet werden. Die metallischen Stoffe sind reine Metalle oder metallische Legierungen, insbesondere Werkstoffe aus der Gruppe der MCrAIY-Legierungen, mit M = Ni, Co, CoNi oder Fe, oder intermetallische Phasen, beispielsweise NiAI-Verbindungen. Die oxidkeramischen Werkstoffe sind Oxide von Zr, Al, Ti, Cr, Ca, Mg, Si, TI, Y, La, Ce, Sc, Pr, Dy, Gd oder Kombinationen dieser chemischen Elemente.

Dem Prozessgasgemisch G kann ein reaktives Gas zugespeist werden, das beispielsweise eine Kohlenwasserstoffverbindung, Sauerstoff und/oder Stickstoff enthält und das mit dem Beschichtungsmaterial M im Prozessstrahl 2 zu einem Teil reagiert. Die dabei entstehenden Verbindungen, die insbesondere Oxide, Nitride, Boride, Silicide, Karbide oder Aluminide sind, werden mit dem nicht reagierten Teil des Beschichtungsmaterials M auf dem Substrat 3 abgeschieden.

Durch Anlegen eines elektrischen Potentials zwischen Brennerelektroden und Substrat 3 wird die Ausbildung der Schichtstruktur 4 beeinflusst (sogenanntes "Biasing") Es ist sowohl eine positive als auch negative Vorspannung möglich. Dabei kann durch Ausbildung eines übertragenen Lichtbogens oder durch eine zusätzliche Vorwärmung des Substrats die Ausbildung der Schichtstruktur 4 beeinflusst werden.

Der Prozessstrahl 2 ist eine Wärmequelle. Es kann eine zusätzliche Wärmequelle verwendet werden. Ausserdem kann eine Wärmesenke vorgesehen sein. Die Temperatur des Substrats 3 kann durch Beeinflussung eines Wärmeeintrags durch die Wärmequelle bzw. einer Wärmeabfuhr durch die Wärmesenke gesteuert oder geregelt werden. Das Auftragen des Beschichtungsmaterials M kann so bei vorgegebenen, den Prozessbedingungen angepassten Temperaturen durchgeführt werden.

Der Substratwerkstoff kann aus organischem und/oder anorganischem Material bestehen und dabei gegebenenfalls als Verbundwerkstoff vorliegen. Das Substrat 3 kann zumindest teilweise aus einem metallischen Werkstoff, insbesondere einer Legierung, und/oder einem keramischen Material bestehen. Das Substrat 3 wird beispielsweise durch den Grundkörper einer Turbinenschaufel gebildet. Oder es kann als eine Komponente einer Brennstoffzelle vorliegen.

Das erfindungsgemässe Verfahren lässt sich beispielsweise anwenden, um eine Beschichtung mit einer stark heterogenen Gefügestruktur zu erzeugen. Eine solche Gefügestruktur ist insbesondere ein Mischgefüge, welches ein poröses Grundgefüge und darin eingebettete, nicht reagierte Materialpartikel umfasst.

## Patentansprüche

1. Hybrides Verfahren zum Beschichten eines Substrats (3) durch ein thermisches Aufbringen der Beschichtung mit einem Prozessstrahl (2), dessen Eigenschaften durch steuerbare Prozessparameter bestimmt sind, insbesondere durch die Parameter Druck, Enthalpie, Zusammensetzung eines Prozessgasgemisches (G) und Zusammensetzung sowie Applikationsform eines Beschichtungsmaterials (M), wobei das Beschichtungsmaterial in Abhängigkeit von den steuerbaren Parametern teilweise oder vollständig verdampft wird und dessen in dampfförmiger (23b) und gegebenenfalls kondensierter, d.h. fester oder flüssiger Form vorliegenden Phasen (23a) auf dem Substrat zumindest teilweise abgeschieden werden,
**dadurch gekennzeichnet, dass** für das im Prozessstrahl transportierte Beschichtungsmaterial (23) der relative Anteil an Dampf und/oder an kondensierter Phase durch ein diagnostisches Messverfahren (D) bestimmt wird und dass mit derart gewonnenen Messdaten (65) die steuerbaren Prozessparameter in Bezug auf Sollwerte eingestellt werden, wobei bezüglich diesen Sollwerten, welche einem vorgegebenen Dampfanteil oder Anteil an kondensierter Phase entsprechen, eine Regelung (C) zur gezielten Herstellung der Beschichtung, insbesondere eines mehrlagigen Schichtsystems (4), durchgeführt wird.

2. Verfahren nach Anspruch 1, **dadurch gekennzeichnet, dass** der Prozessstrahl (2) ein von Plasma (22) durchströmter Raum ist, in dem das Prozessgasgemisch (G) und das Beschichtungsmaterial (M, 23) transportiert wird, wobei das Plasma mit einem bekannten Verfahren (P) erzeugt wird, nämlich mittels elektrischer Gasentladung, elektromagnetischer Induktion oder Mikrowellen.

3. Verfahren nach Anspruch 1 oder 2, **dadurch gekennzeichnet, dass** zur Diagnostik (D) des Prozessstrahls (2) ein optisches Messverfahren angewendet wird, bei dem insbesondere der Dampfanteil mittels eines spektroskopischen oder pyrometrischen Verfahrens bestimmt wird und/oder der Anteil der kondensierten Phase, die in Form einer Vielzahl von Tröpfchen und/oder Partikeln vorliegt, mittels einer Streulichtmessung unter Verwendung einer Hilfslichtquelle, insbesondere eines Lasers bestimmt wird.

4. Verfahren nach einem der Ansprüche 1 bis 3, **dadurch gekennzeichnet, dass** die Applikationsform, in der das Beschichtungsmaterial (M) in den Prozessstrom injiziert wird (13), ein Pulver und/oder eine Flüssigkeit, insbesondere eine Suspension, und/oder ein Gas, insbesondere ein gasförmiger Prekursor, ist, wobei unter Verwendung mehrerer Injektoren sich wahlweise verschiedene Ausgangsmaterialien gleichzeitig injizieren lassen.

5. Verfahren nach einem der Ansprüche 1 bis 4, **dadurch gekennzeichnet, dass** für das Beschichtungsmaterial (M) metallische und/oder nichtmetallische, insbesondere oxidkeramische Stoffe verwendet werden, dass die metallischen Stoffe reine Metalle oder metallische Legierungen, insbesondere Werkstoffe aus der Gruppe der MCrAlY-Legierungen, mit M = Ni, Co, CoNi oder Fe, oder intermetallische Phasen, beispielsweise NiAl-Verbindungen, sind und dass die oxidkeramische Werkstoffe Oxide von Zr, Al, Ti, Cr, Ca, Mg, Si, Tl, Y, La, Ce, Sc, Pr, Dy, Gd oder Kombinationen dieser chemischen Elemente sind.

6. Verfahren nach einem der Ansprüche 1 bis 5, **dadurch gekennzeichnet, dass** dem Prozessgasgemisch (G) ein reaktives Gas zugespeist wird, das beispielsweise eine Kohlenwasserstoffverbindung, Sauerstoff und/oder Stickstoff enthält und mit dem das Beschichtungsmaterial (23) im Prozessstrahl (2) zu einem Teil reagiert, und dass die dabei entstandenen Verbindungen, die insbesondere Oxide, Nitride, Boride, Silicide, Karbide oder Aluminide sind, mit dem nicht reagierten Teil auf dem Substrat (3) abgeschieden werden.

7. Verfahren nach einem der Ansprüche 1 bis 6, **dadurch gekennzeichnet, dass** als Beschichtungsmaterial (23) Verbindungen vom Typ MₓO_{y}N_{z} abgeschieden werden, wobei M ein Metall ist, insbesondere Zr, Al, Cr, Ti, Ta oder andere Metalle, die eine thermodynamisch stabile Verbindung von diesem Typ ausbilden.

8. Verfahren nach einem der Ansprüche 1 bis 7, **dadurch gekennzeichnet, dass** durch Anlegen eines elektrischen Potentials zwischen Brennerelektroden und Substrat (3) die Ausbildung der Schichtstruktur (4) beeinflusst wird.

9. Verfahren nach einem der Ansprüche 1 bis 8, **dadurch gekennzeichnet, dass** eine zusätzliche Wärmequelle und/oder eine Wärmesenke verwendet werden, um das Auftragen des Beschichtungsmaterials (M) bei vorgegebenen, den Prozessbedingungen angepassten Temperaturen durchzuführen, wobei die Temperatur des Substrats (3) durch Beeinflussung eines Wärmeeintrags durch die Wärmequelle bzw. einer Wärmeabfuhr durch die Wärmesenke gesteuert oder geregelt wird.

10. Verfahren nach einem der Ansprüche 1 bis 9, **dadurch gekennzeichnet, dass** das Substrat (3) aus organischem und/oder anorganischem Material besteht und dabei gegebenenfalls als ein Verbundwerkstoff vorliegen kann.

11. Anwendung des Verfahrens gemäss einem der Ansprüche 1 bis 10, **dadurch gekennzeichnet, dass** eine Beschichtung auf einer Turbinenschaufel oder einer Komponente einer Brennstoffzelle hergestellt wird.

12. Anwendung des Verfahrens gemäss einem der Ansprüche 1 bis 10, **dadurch gekennzeichnet, dass** die Morphologie des auf dem Substrat (3) abgeschiedenen Schichtsystems (4) - abhängig vom Beschichtungsmaterial (M), dem Prozessdruck und der Temperatur des Substrats - zumindest teilweise eine Gefügestruktur (4a, 4b) aufweist, deren Charakter zumindest angenähert lamellar ist wie bei üblichen thermischen Spritzschichten oder kolumnar wie bei besonderen Wärmedämmschichten, die mittels Abscheiden von verdampftem Beschichtungsmaterial (23b) erzeugt werden.

13. Anwendung nach Anspruch 12, **dadurch gekennzeichnet, dass** die Gefügestruktur stark heterogen ist, insbesondere ein Mischgefüge, welches ein poröses Grundgefüge und darin eingebettete, nicht reagierte Materialpartikel umfasst.

## Claims

1. A hybrid method for the coating of a substrate (3) by a thermal application of the coating using a process jet (2) whose properties are defined by controllable process parameters, in particular by the parameters of pressure, enthalpy, composition of a process gas mixture (G) and composition as well as form of application of a coating material (M), with the coating material being partly or completely evaporated in dependence on the controllable parameters and its phases present in vapour form (23b) and, optionally, in condensed, i.e. solid or liquid form (23a) being at least partly deposited on the substrate,
**characterised in that** the relative proportion of vapour and/or of condensed phase for the coating material (23) transported in the process jet is determined by a diagnostic measuring method (D); and **in that** the controllable process parameters are set with respect to desired values using such gained measured data (65), with a regulation (C) being carried out with respect to these desired values, which correspond to a pre-determined vapour proportion or to a proportion of condensed phase, for the direct manufacture of the coating, in particular of a multi-layer coating system (4).

2. A method in accordance with claim 1, **characterised in that** the process jet (2) is a space through which plasma (22) flows and in which the process gas mixture (G) and the coating material (M, 23) are transported, with the plasma being produced with a known process (P), namely by means of electrical gas discharge, electromagnetic induction or microwaves.

3. A method in accordance with claim 1 or claim 2, **characterised in that** an optical measuring process is used for the diagnosis (D) of the process jet (2) in which in particular the vapour proportion is determined by means of a spectroscopic or pyrometric process and/or the proportion of the condensed phase, which is present in the form of a plurality of droplets and/or particles, is determined by means of a scattered light measurement using an auxiliary light source, in particular a laser.

4. A method in accordance with any one of claims 1 to 3, **characterised in that** the form of application in which the coating material (M) is injected into the process stream (13) is a powder and/or a liquid, in particular a suspension, and/or a gas, in particular a gaseous precursor, with, optionally, different starting materials being able to be injected simultaneously using a plurality of injectors.

5. A method in accordance with any one of claims 1 to 4, **characterised in that** metallic and/or non-metallic, in particular oxide ceramic substances, are used for the coating material (M); **in that** the metallic substances are pure metals or metallic alloys, in particular material from the group of MCrAlY alloys, where M = Ni, Co, CoNi or Fe, or intermetallic phases, for example NiAl compounds; and **in that** the oxide ceramic materials are oxides of Zr, Al, Ti, Cr, Ca, Mg, Si, Tl, Y, La, Ce, Sc, Pr, Dy, Gd or combinations of these chemical elements.

6. A method in accordance with any one of claims 1 to 5, **characterised in that** a reactive gas is fed to the process gas mixture (G) and includes, for example, a hydrocarbon compound, oxygen and/or nitrogen and reacts with one part of the coating material (32) in the process jet (2); and **in that** the compounds created, which are in particular oxides, nitrides, borides, silicides, carbides or aluminides, are deposited onto the substrate (3) with the non-reacted part.

7. A method in accordance with any one of claims 1 to 6, **characterised in that** compounds of the type MₓO_{y}N_{z} are deposited as the coating material (23), where M is a metal, in particular Zr, Al, Cr, Ti, Ta or other metals which form a thermodynamically stable compound of this type.

8. A method in accordance with any one of claims 1 to 7, **characterised in that** the formation of the layer structure (4) is influenced by application of an electrical potential between burner electrodes and the substrate (3).

9. A method in accordance with any one of claims 1 to 8, **characterised in that** an additional heat source and/or a heat sink are used to carry out the application of the coating material (M) at pre-determined temperatures matched to the process conditions, with the temperature of the substrate (3) being controlled or regulated by influencing of a heat input by the heat source or of the heat sink.

10. A method in accordance with any one of claims 1 to 9, **characterised in that** the substrate (3) consists of organic and/or inorganic material and can, optionally, be present as a composite material.

11. Use of the method in accordance with any one of claims 1 to 10, **characterised in that** a coating is produced on a turbine vane or on a component of a fuel cell.

12. Use of the method in accordance with any one of claims 1 to 10, **characterised in that** the morphology of the layer system (4) deposited on the substrate (3) at least partly has - dependent on the coating material (M), on the process pressure and on the temperature of the substrate - a material structure (4a, 4b) whose character is at least approximately lamellar, as with conventional thermal spray coatings, or columnar, as with special heat insulating layers which are produced by means of deposition of evaporated coating material (23b).

13. Use in accordance with claim 12, **characterised in that** the material structure is very heterogeneous, in particular a mixed structure, which includes a porous base structure and non-reacted material particles embedded therein.

## Revendications

1. Procédé hybride pour le dépôt d'un revêtement sur un substrat (3) par un dépôt thermique du revêtement, avec un faisceau de processus (2) dont les propriétés sont déterminées par des paramètres de processus spécifiables, en particulier par les paramètres pression, enthalpie, composition d'un mélange de gaz de processus (G), et composition ainsi que forme d'application du matériau de revêtement (M), sachant que le matériau de revêtement est vaporisé en partie ou complètement en fonction des paramètres spécifiables et que ses phases, se présentant sous forme de vapeur (23b) et, le cas échéant, condensée (23a), c'est-à-dire solide ou liquide, sont déposées au moins en partie sur le substrat,
**caractérisé en ce que** pour le matériau de revêtement (23) transporté dans le faisceau de processus, la proportion relative de vapeur et/ou de phase condensée est déterminée par un procédé de mesure diagnostique (D) et **en ce qu'**avec des données de mesure (65) ainsi obtenues, les paramètres de processus spécifiables sont réglés du point de vue des valeurs de consigne, sachant que concernant ces valeurs de consigne, lesquelles correspondent à une proportion prédéfinie de vapeur ou de phase condensée, une régulation (C) est effectuée pour la préparation ciblée du revêtement, en particulier d'un système de couches (4) en plusieurs épaisseurs.

2. Procédé selon la revendication 1, **caractérisé en ce que** le faisceau de processus (2) est un espace traversé par du plasma (22), dans lequel le mélange de gaz de processus (G) et le matériau de revêtement (M, 23) sont transportés, sachant que le plasma est engendré par un procédé (P) connu, en l'occurrence au moyen d'une décharge électrique dans un gaz, d'une induction électromagnétique ou de micro-ondes.

3. Procédé selon la revendication 1 ou 2, **caractérisé en ce que** pour le diagnostic (D) du faisceau de processus (2), un procédé de mesure optique est appliqué, dans lequel en particulier la proportion de vapeur est déterminée au moyen d'un procédé spectroscopique ou pyrométrique et/ou la proportion de la phase condensée, qui se présente sous la forme d'une multitude de gouttelettes et/ou de particules, est déterminée au moyen d'une mesure de lumière diffusée moyennant l'utilisation d'une source de lumière auxiliaire, en particulier d'un laser.

4. Procédé selon l'une quelconque des revendications 1 à 3, **caractérisé en ce que** la forme d'application dans laquelle le matériau de revêtement (M) est injecté (13) dans le courant de processus, est une poudre et/ou un liquide, en particulier une suspension, et/ou un gaz, en particulier un précurseur gazeux, sachant que moyennant l'utilisation de plusieurs injecteurs, différents matériaux de départ peuvent être injectés au choix en même temps.

5. Procédé selon l'une quelconque des revendications 1 à 4, **caractérisé en ce que** pour le matériau de revêtement (M) sont utilisés des substances métalliques et/ou non métalliques, en particulier des oxydes céramiques, **en ce que** les substances métalliques sont des métaux purs ou des alliages métalliques, en particulier des matériaux du groupe des alliages MCrAlY, avec M = Ni, Co, CoNi ou Fe, ou des phases intermétalliques, par exemple des composés NiAl, et **en ce que** les matériaux à base d'oxydes céramiques sont des oxydes de Zr, Al, Ti, Cr, Ca, Mg, Si, Tl, Y, La, Ce, Sc, Pr, Dy, Gd ou des combinaisons de ces éléments chimiques.

6. Procédé selon l'une quelconque des revendications 1 à 5, **caractérisé en ce qu'**au mélange de gaz de processus (G) est ajouté un gaz réactif, qui contient par exemple un composé hydrocarbure, de l'oxygène et/ou de l'azote et avec lequel le matériau de revêtement (23) dans le faisceau de processus (2) réagit en partie, et **en ce que** les composés qui sont produits ce faisant, qui sont en particulier des oxydes, des nitrures, des borures, des siliciures, des carbures ou des aluminiures, sont déposés sur le substrat (3) avec la partie n'ayant pas réagi.

7. Procédé selon l'une quelconque des revendications 1 à 6, **caractérisé en ce que** comme matériau de revêtement (23), des composés de types MxOyNz sont déposés, dans lesquels M est un métal, en particulier Zr, Al, Cr, Ti, Ta ou d'autres métaux qui forment un composé thermodynamiquement stable de ce type.

8. Procédé selon l'une quelconque des revendications 1 à 7, **caractérisé en ce que** par la mise d'un potentiel électrique entre les électrodes de la torche et le substrat (3), la formation de la structure en couche (4) est influencée.

9. Procédé selon l'une quelconque des revendications 1 à 8, **caractérisé en ce qu'**une source de chaleur supplémentaire et/ou un puits de chaleur sont utilisés pour le dépôt du matériau de revêtement (M) à des températures prédéfinies adaptées aux conditions du processus, sachant que la température du substrat (3) est commandée ou régulée par influencement d'une introduction de chaleur par la source de chaleur, respectivement d'un soutirage de chaleur par un puits de chaleur.

10. Procédé selon l'une quelconque des revendications 1 à 9, **caractérisé en ce que** le substrat (3) consiste en matériau organique et/ou inorganique et peut se présenter ce faisant comme un matériau composite.

11. Application du procédé selon l'une quelconque des revendications 1 à 10, **caractérisée en ce qu'**un revêtement est élaboré sur une pale de turbine ou sur un composant d'une pile à combustible.

12. Application du procédé selon l'une quelconque des revendications 1 à 10, **caractérisée en ce que** la morphologie du système de couches (4) déposé sur le substrat (3) - en fonction du matériau de revêtement (M), de la pression de processus et de la température du substrat - comporte au moins en partie une structure (4a, 4b) dont le caractère est au moins approximativement lamellaire comme avec les couches thermiques pulvérisées conventionnelles, ou aciculaire comme dans des couches calorifuges particulières qui sont engendrées par dépôt de matériau de revêtement vaporisé (23b).

13. Application du procédé selon la revendication 12, **caractérisée en ce que** la structure est fortement hétérogène, en particulier une structure mixte, laquelle comprend une structure de base poreuse et des particules de matériau n'ayant pas réagi encastrées dedans.
